# FASCICULE DE BREVET EUROPEEN

(11) **EP 1 260 938 B1**
(45) Date de publication et mention de la délivrance du brevet: **17.12.2003**
(21) Numéro de dépôt: 02015180.9
(22) Date de dépôt: 25.03.1998
(51) Int. Cl.: G06K 19/077

(54) **Connexion souple par dispense entre puce et interface avec ou sans contact**
Flexibele Verbindung zwischen Chip und kontaktbehafteter oder kontaktloser Schnittstelle
Flexible connection between chip and interface with or without contact

(30) Priorité: 27.03.1997 FR 9704093
(43) Date de publication de la demande: 27.11.2002
(62) Demande divisionnaire de: 98917221.8
(73) Titulaire: GEMPLUS, 13420 Gémenos (FR)
(72) Inventeur: Fidalgo, Jean-Christophe, 13420 Gemenos (FR); Blanc, René-Paul, 83860 Nans les Pins (FR); Patrice, Philippe, 13011 Marseille (FR)

(56) Documents cités:
- EP-A- 0 762 323
- DE-A- 4 325 458
- FR-A- 2 624 284

## Description

L'invention concerne des dispositifs électroniques comportant au moins un microcircuit qui est noyé dans une carte support et relié à des éléments d'interface constitués par un bornier et/ou une antenne, tels que les cartes à circuit(s) intégré(s) avec ou sans contact, aussi appelées cartes à puce.

L'invention s'applique aussi, en particulier, aux étiquettes électroniques qui sont utilisées pour l'identification de produits et que l'on peut assimiler à des cartes à puces sans contact .

La présente invention concerne plus particulièrement les connexions entre le microcircuit et les éléments d'interface, tels que le bornier et/ou une antenne.

Il existe de nombreux procédés de fabrication des cartes à puce à contacts. La majorité de ces procédés est basée sur l'assemblage de la puce dans un sous-ensemble appelé micromodule qui est assemblé en utilisant des procédés traditionnels.

Un premier procédé comprend tout d'abord le collage de la puce ou microcircuit ("die attach") en disposant sa face active avec ses plots de sortie vers le haut et en collant la face opposée sur une plaque support diélectrique.

On effectue ensuite le microcâblage ou soudage des connexions ("wire bonding") qui consiste à réaliser par des soudures la connexion des plots de sortie de la puce avec le bornier de contacts de la plaque de circuit imprimé.

Enfin, on effectue un enrobage en boîtier ("potting") qui consiste à protéger la puce et les fils de connexion soudés en utilisant une résine.

Le document US-A-5969415 décrit un dispositif de stockage de données, dans lequel une puce est reliée à une bobine d'antenne par des liaisons filaires soudées à des tiges de contact. Ces tiges sont fixées à la bobine par une colle électriquement conductrice, préalablement introduite dans des passages correspondants par une technique dite de « dispense ».

Le document JP-A-07321438 décrit un montage sur une carte de circuit imprimé par sérigraphie puis durcissement thermique, d'une puce avec sa face active tournée vers ce circuit. Des bossages de la puce sont ensuite revêtus d'un adhésif conducteur durcissable à la chaleur. Une autre réalisation montre un pacquetage à puce semi conductrice avec une connexion filaire dite « wire bonding ».

Le document FR-A 2 624 284 divulgue une carte à puce où les connexions électriques d'un composant électronique sont reliées à des métallisations de la carte par une substance liquide ou visqueuse. Les connexions du composant sont introduites dans des canaux contenant cette substance.

Dans une variante de ce procédé, on utilise la technique du soudage sur bande ("tape automated bonding ou TAB"), selon laquelle la puce est collée au moyen d'une colle anisotrope et les différents contacts du film sont soudés par thermocompression sur la puce qui comporte des bosses.

Il existe aussi des procédés de fabrication des cartes à puce à contacts n'utilisant pas de micromodule. Un premier procédé est basé sur l'utilisation de la sérigraphie pour former des contacts et assurer l'interconnexion de la puce.

Un autre procédé fait appel à une métallisation en trois dimensions du corps de la carte, suivie d'un report de la puce par une technologie classique (collage plus microcâblage) ou par la technique du "flip-chip".

Dans les procédés utilisant un micromodule, les coûts associés sont limités par le prix du film. De plus, il est souvent nécessaire, après l'opération d'encapsulation, de fraiser la résine pour réduire l'épaisseur de l'ensemble. Cette opération est difficile à réaliser car la résine est polymérisée et donc très rigide. Ce fraisage est la cause principale des rebuts de fabrication.

Dans le premier procédé sans micromodule, ce dernier se trouve en surface et il est donc soumis aux contraintes extérieures, ce qui augmente fortement le coût associé. En ce qui concerne le deuxième procédé sans micromodule, le nombre d'étapes est important, ce qui en augmente le coût.

Il n'est donc pas envisageable d'utiliser une telle technologie pour la fabrication de cartes à puce de grande taille.

Le problème à la base de l'invention est de disposer de connexions entre un microcircuit et les éléments d'interface, dans un dispositif électronique (tel qu'une carte à puce) qui permet de réduire le coût et le pourcentage de rebuts de fabrication.

L'invention est définie dans les revendications.

On obtient des connexions souples alors que les connexions de type connu sont rigides ou semi-rigides et cela réduit fortement le taux de rebut à la fabrication.

D'autres caractéristiques et avantages de l'invention apparaîtront à la lecture de la description détaillée des dessins annexés dans lesquels :
- la figure 1 illustre un premier mode de réalisation du procédé selon l'invention appliqué à la fabrication de cartes à puces à contacts ;
- la figure 2 illustre une variante du procédé de la figure 1 ;
- la figure 3 illustre un mode de réalisation appliqué à la fabrication de cartes à puces sans contact ;
- les figures 4 à 7 illustrent une variante du procédé de la figure 3 ;
- la figure 8 illustre un mode de réalisation appliqué à la fabrication de cartes à puces hybrides ; et
- les figures 9 et 10 illustrent un mode de réalisation appliqué à la fabrication d'étiquettes électroniques.

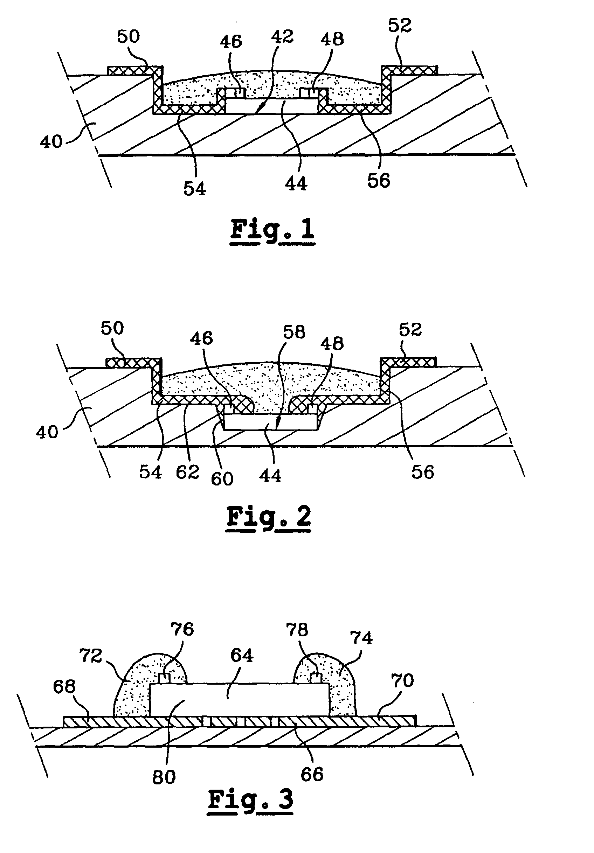

La figure 1 représente une carte à puce à contacts fabriquée conformément à un procédé selon l'invention.

Dans une première étape, on réalise un corps de carte 40 comportant une cavité 42 qui peut être réalisée par moulage par injection ou par colamination de feuilles thermoplastiques suivie d'un usinage de la cavité.

Dans une deuxième étape, on met la puce 44 dans la cavité avec sa face active, en particulier ses plots de sortie 46 et 48, vers le haut et on la fixe par exemple par collage. On peut aussi procéder à un chauffage local de la cavité puis à une mise en place de la puce dans la matière thermoplastique ainsi fondue. Il n'est pas nécessaire que la face active de la puce soit au même niveau que le fond de la cavité.

Dans une troisième étape, on réalise le bornier de contacts et les connexions avec les plots de sortie 46 et 48 en déposant une substance conductrice à faible viscosité, par exemple une résine polymère chargée de particules conductrices ou intrinsèquement conductrices, par une technique dite de "dispense" selon laquelle on applique une substance liquide ou de faible viscosité au moyen d'une seringue ou analogue à débit et ouverture commandés.

Cette opération de dépôt, appelée dans la suite dispense, est réalisée par exemple au moyen d'une installation commercialisée sous la dénomination CAM/ALOT par la société américaine Camelot Systems Inc. et utilisée pour la réalisation en ligne de circuits électroniques. Les paramètres de déplacement et d'ouverture de la seringue sont commandés par un programme informatique.

On réalise ainsi des dépôts de résine conductrice qui constituent les contacts 50 et 52 du bornier d'interface de la carte à puce et les connexions 54 et 56 entre ces contacts 50 et 52 et les plots de sortie 46 et 48 de la puce. L'épaisseur de ces dépôts peut être beaucoup plus élevée que par un procédé de sérigraphie, ce qui permet d'obtenir des sections plus importantes et donc de faibles résistances de contact.

Avantageusement, les plots de sortie 46 et 48 comportent une métallisation inoxydable, par exemple en nickel, titane ou tungstène.

On peut aussi munir ces plots de bosses (bumps) de manière à améliorer le contact électrique.

Pour corriger les erreurs de positionnement de la puce, on peut prévoir une régulation utilisant une image de la puce fournie par un système de vision assisté par ordinateur (VAO).

On choisit, de préférence, des résines dont la température d'activation est inférieure à la température de ramollissement de la matière thermoplastique du corps de la carte.

La figure 2 illustre une variante du procédé précité dans laquelle on réalise une cavité à deux niveaux, c'est-à-dire une cavité 58 présentant un évidement 60 dans son fond. Les dimensions de cet évidement sont suffisantes pour recevoir la puce 44 et sa profondeur est sensiblement égale à l'épaisseur de la puce de telle sorte que la face active de celle-ci se trouve au niveau du fond 62 de la cavité 58. Grâce à cette disposition, on évite un deuxième changement de pente des cordons de résine dans la cavité, ce qui facilite le contact de la résine conductrice avec les plots de sortie 46 et 48.

Dans une quatrième et dernière étape, on réalise une encapsulation (potting) qui, consiste à protéger la puce en utilisant une résine, par exemple à base de silicone ou de polyuréthanne.

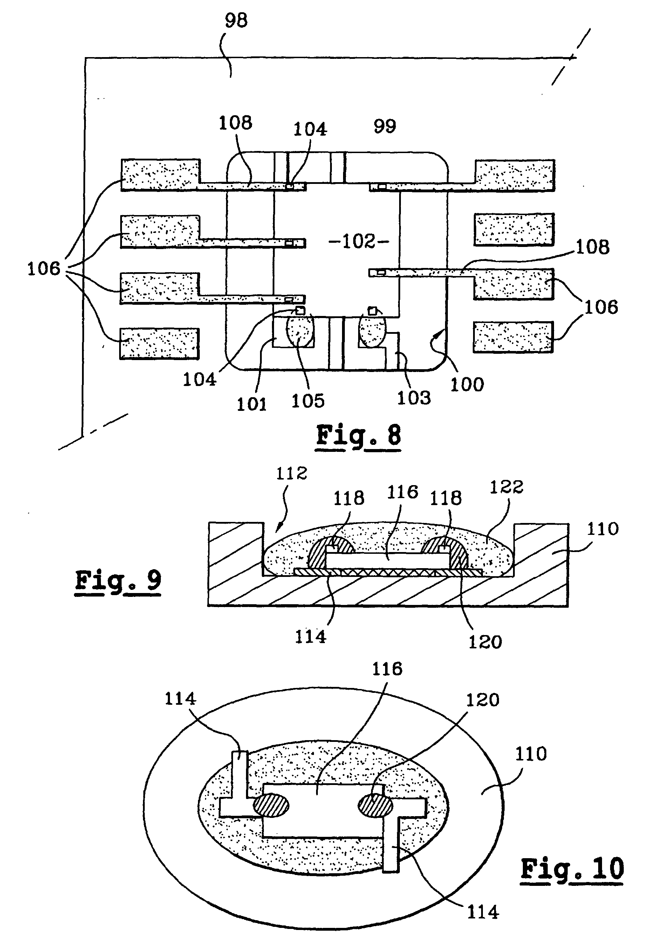

La figure 3 représente une carte à puce sans contact fabriquée conformément à un procédé selon l'invention. Elle comporte une antenne "à plat" constituée par une piste ayant, par exemple, la forme d'une spirale rectangulaire disposée à la périphérie de la carte comme représenté sur la figure 9.

Dans une première étape, on effectue un collage d'une puce 64 avec sa face active vers le haut à l'endroit choisi pour la connexion en utilisant un procédé et un équipement classique de "die attach" en utilisant une colle 66 permettant un collage sur un circuit imprimé ou un film. On choisit une colle compatible avec la température maximale d'utilisation du support de l'antenne, par exemple un adhésif réticulant sous l'effet d'une exposition à un rayonnement ultraviolet. La cadence de cette opération de collage peut être particulièrement élevée, par exemple cinq à six mille pièces à l'heure avec une seule tête. On s'attachera à obtenir un congé de colle parfaitement maîtrisé dans la zone du périmètre de la puce située en regard des plages de connexion 68 et 70 de l'antenne.

Dans une deuxième étape, on réalise des connexions électriques 72 et 74 en résine conductrice entre les plots de sortie 76 et 78 de la puce 80 et les plages de connexion 68 et 70 de l'antenne.

Cette deuxième étape peut aussi être réalisée avec la même cadence élevée de l'étape de collage de la puce. Ces deux étapes peuvent être réalisées sur un même équipement.

Selon une première variante, l'antenne à plat est réalisée par une technique de "dispense" et le collage de la puce est effectué par la technique de "flip chip" décrite ci-dessus.

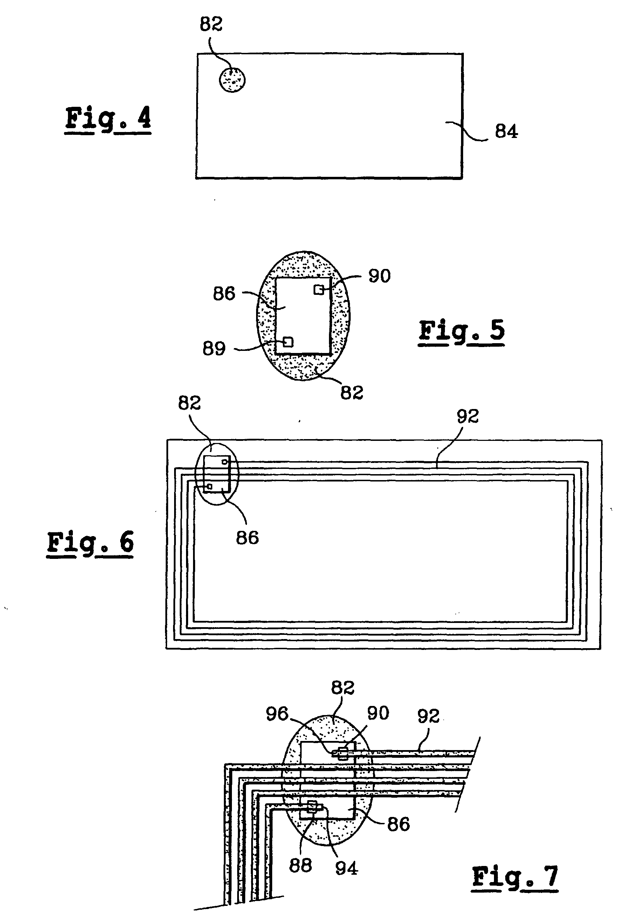

Selon une autre variante illustrée sur les figures 4 à 7, on fixe d'abord la puce et on réalise l'antenne par une technique de "dispense" en passant sur la face active de la puce.

Dans une première étape (figure 4), on dépose par dispense un adhésif isolant 82, par exemple de type époxy, sur un support 84, par exemple en polychlorure de vinyle ou en polyéthylène, à l'endroit où on posera ensuite une puce munie de bosses de contact.

On pourrait ainsi utiliser des adhésifs destinés à la technique de "die attach" adaptés au support.

Dans une deuxième étape (figure 5), on place une puce 86 avec sa face active vers le haut sur l'adhésif 82 pour réaliser un collage de type "die attach". L'intérêt des bosses de contact est d'améliorer le contact électrique entre les plots de sortie 88 et 90 de la puce et l'antenne. On procédera éventuellement à une isolation des plots de sortie non fonctionnels en déposant un vernis diélectrique.

Dans une troisième étape (figure 6), on réalise l'antenne 92 par une technique de dispense d'une substance conductrice, par exemple une encre ou une colle, avec déplacement de la seringue en utilisant par exemple l'équipement CAM/ALOT cité ci-dessus.

On voit sur la figure 7 que les extrémités 94 et 96 de la spirale rectangulaire constituant l'antenne 92 recouvrent, respectivement, les plots de contacts 88 et 90 de la puce 86.

Dans une dernière et quatrième étape, on réalise une opération de colamination pour terminer la carte.

La figure 8 représente une carte à puce hybride fabriquée conformément à un procédé selon l'invention. Dans ce cas, on combine deux procédés précédemment décrits.

Dans une première étape, on réalise un corps de carte 98 comportant une antenne incorporée 99 comportant deux plots de contact 101 et 103. Dans une deuxième étape, on réalise une cavité 100 dans le corps de la carte. Dans une troisième étape, on fixe la puce 102 avec sa face active et ses plots de sortie 104, qui comportent de préférence une métallisation inoxydable, dans la cavité, par exemple par collage.

Dans une quatrième étape, on réalise le bornier de contacts 106 et ses connexions 108 avec les plots de sortie 104 de la puce et les connexions 105 des plots de contact 101 et 103 de l'antenne avec les plots de sortie 104 en déposant une résine conductrice 105 par une technique de dispense. Les plots 104 peuvent comporter des bosses de contact.

Les erreurs de positionnement angulaire de la puce 102 peuvent être corrigées comme décrit ci-dessus en utilisant un équipement de vision assistée par ordinateur.

Dans une cinquième et dernière étape, on réalise l'encapsulation de la puce.

L'invention s'applique à la fabrication de tous les dispositifs électroniques comprenant au moins un microcircuit qui est noyé dans une carte support et qui comporte des plots de sortie reliés à des éléments d'interface constitués par un bornier et/ou une antenne. En particulier, l'invention permet de fabriquer des étiquettes électroniques comme représenté sur les figures 9 et 10.

Un support 110 comporte une cavité 112 dans le fond de laquelle est réalisée une antenne 114. On y fixe ensuite un microcircuit 116 avec ses plots de sortie 118 vers le haut. On applique une résine conductrice 120 par une technique de dispense pour réaliser les connexions entre l'antenne 114 et les plots de sortie 118 de la puce. On réalise ensuite une encapsulation avec une résine isolante 122.

On voit que l'invention permet de supprimer la réalisation d'un micromodule et, en particulier l'opération de fraisage. Il en résulte de plus que le taux de rebuts de fabrication est très fortement réduit.

Par ailleurs, le nombre des étapes est réduit, ce qui simplifie fortement la fabrication et entraîne une diminution importante prix de revient. Cet effet est encore accru par le fait que certaines opérations de collage de la puce et de réalisation des connexions peuvent être réalisées avec le même équipement.

L'invention n'utilise pas d'équipements coûteux, ce qui réduit les coûts de fabrication.

La réalisation de l'antenne par la technique de dispense permet d'obtenir une surface maximale et, par suite, d'augmenter les performances de l'antenne par rapport aux antennes bobinées incorporées classiques.

L'invention permet de fabriquer, de manière simple et peu coûteuse des cartes complexes et de grandes dimensions.

La réalisation des connexions par la technique de "dispense" d'une substance qui reste souple après son activation permet de diminuer la rigidité et d'augmenter considérablement la résistance à la flexion-torsion des cartes à puce. Ainsi, les cartes à puce fabriquées conformément à l'invention ont une tenue aux contraintes qui est beaucoup plus élevée que celle imposée par les normes actuelles.

L'invention permet d'obtenir, avec un très faible taux de rebut comme on l'a indiqué plus haut, des cadences de fabrication élevées, par exemple de l'ordre de 4000 cartes à puce à l'heure.

## Revendications

1. Dispositif électronique, tel qu'une carte à puce, comprenant au moins un microcircuit (44 ; 80 ; 86 ; 102) qui est noyé dans une carte support (40; 84 ; 98) et qui comporte des plots de sortie (46, 48 ; 76, 78 ; 88, 90 ; 104) reliés à des éléments d'interface constitués par un bornier (50, 52 ; 106) et/ou une antenne (70 ; 92 ; 99 ; 103), où l'on réalise les connexions (54, 56 ; 72, 74 105 ; 108) entre les plots de sortie (46, 48 ; 76, 78 ; 88, 90 ; 104) et les éléments d'interface avec une substance conductrice ;
**caractérisé en ce que** la substance conductrice déposée au moyen d'une seringue ou analogue, est à faible viscosité et reste souple après son application et sa polymérisation et le dépôt réalise un cordon.

2. Dispositif selon la revendication 1, **caractérisé en ce que** le bornier (106) est en substance conductrice à faible viscosité et souple.

3. Dispositif selon la revendication 1, **caractérisé en ce qu'**une antenne (92) est en substance conductrice à faible viscosité et souple.

4. Dispositif selon l'une des revendications 1 à 3, **caractérisé en ce que** la substance est une résine polymère chargée de particules conductrices.

5. Dispositif selon l'une des revendications 1 à 3, **caractérisé en ce que** la substance est une résine polymère chargée de particules intrinsèquement conductrices.

6. Dispositif selon l'une des revendications 1 à 5, **caractérisé en ce que** les plots de sortie comportent une métallisation inoxydable.

7. Dispositif selon la revendication 2, **caractérisé en ce qu'**il s'agit d'une carte à puce à contacts, un corps de carte (40) comportant une cavité (42), le microcircuit (44) est fixé avec sa face active vers le haut dans la cavité, (42), le bornier (50, 52) et les connexions étant (54, 56) en substance conductrice et **en ce que** le microcircuit (44) est encapsulé.

8. Dispositif selon la revendication 7, **caractérisé en ce que** le microcircuit (44) comporte des bosses de contact.

9. Dispositif selon la revendication 8, **caractérisé en ce que** la cavité (58) présente un évidement (60) dans son fond (62) où est reçu le microcircuit (44).

10. Dispositif selon la revendication 1, **caractérisé en ce qu'**il s'agit d'une carte à puce sans contact ou une étiquette électronique, une antenne à plat, **en ce que** le microcircuit (64) est fixé sur la carte avec sa face active vers le haut, et **en ce que** les connexions (72, 74) entre les plots de sortie (76, 78) du microcircuit et les plots (68, 70) de l'antenne sont en substance conductrice à faible viscosité et souple.

11. Dispositif selon la revendication 1, **caractérisé en ce que** sur le microcircuit (86) avec sa face active vers le haut, une antenne à plat (92) est en substance conductrice à faible viscosité, et souple.

## Patentansprüche

1. Elektronische Vorrichtung, wie zum Beispiel eine Chipkarte, mit wenigstens einem Mikroschaltkreis (44; 80; 86; 102), der in einen Kartenträger (40; 84; 98) versenkt und der mit durch eine Klemmstelle (50, 52; 106) und / oder eine Antenne (70; 92; 99; 103) gebildeten Schnittstellenelementen angeschlossene Ausgangssteckstellen (46, 48; 76, 78; 88, 90; 104) umfasst, in der man die Anschlüsse (54, 56; 72, 74; 105; 108) zwischen den Ausgangssteckstellen (46, 48; 76, 78; 88, 90; 104) und den Schnittstellenelementen mit einer leitenden Substanz realisiert;
**dadurch gekennzeichnet, dass** die mittels einer Spritze oder dergleichen aufgebrachte leitende Substanz eine geringe Viskosität hat und nach ihrer Anwendung und ihrer Polymerisierung elastisch bleibt und der Auftrag einen Gürtel realisiert.

2. Vorrichtung gemäß Anspruch 1 ,**dadurch gekennzeichnet, dass** die Klemmstelle (106) aus einer leitenden Substanz mit geringer Viskosität und elastisch ist.

3. Vorrichtung gemäß Anspruch 1, **dadurch gekennzeichnet, dass** eine Antenne (92) aus leitender Substanz mit geringer Viskosität und elastisch ist.

4. Vorrichtung gemäß Anspruch 1 bis 3, **dadurch gekennzeichnet, dass** die Substanz ein mit leitenden Partikeln geladenes Polymerharz ist.

5. Vorrichtung gemäß Anspruch 1 bis 3, **dadurch gekennzeichnet, dass** die Substanz ein mit innerlich leitenden Partikeln geladenes Polymerharz ist.

6. Vorrichtung gemäß Anspruch 1 bis 5, **dadurch gekennzeichnet, dass** die Ausgangssteckstelen einen nicht oxydierbaren Metallauftrag umfassen.

7. Vorrichtung gemäß Anspruch 2, **dadurch gekennzeichnet, dass** es sich um eine Chipkarte mit Kontakt handelt, wobei ein Kartenkörper (40) eine Aushöhlung (42) umfasst, der Mikroschaltkreis (44) mit seiner aktiven Seite nach oben in der Aushöhlung (42) befestigt ist, wobei die Klemmstelle (50, 52) und die Anschlüsse (54, 56) aus leitender Substanz sind und dass der Mikroschaltkreis (44) verkapselt ist.

8. Vorrichtung gemäß Anspruch 7, **dadurch gekennzeichnet, dass** der Mikroschaltkreis (44) Kontakthöcker umfasst .

9. Vorrichtung gemäß Anspruch 8, **dadurch gekennzeichnet, dass** die Aushöhlung (58) eine Aussparung (60) in ihrem Boden (62) aufweist, in der der Mikroschaltkreis (44) aufgenommen wird.

10. Vorrichtung gemäß Anspruch 1, **dadurch gekennzeichnet, dass** es sich um eine Chipkarte ohne Kontakt oder ein elektronisches Etikett und eine flache Antenne handelt und dass der Mikroschaltkreis (64) auf der Karte mit seiner aktiven Seite nach oben befestigt ist und dass die Anschlüsse (72, 74) zwischen den Ausgangssteckstellen (76, 78) des Mikroschaltkreises und der Steckstellen (68, 70) der Antenne in der leitenden Substanz mit geringer Viskosität und elastisch sind.

11. Vorrichtung gemäß Anspruch 1, **dadurch gekennzeichnet, dass** auf dem Mikroschaltkreis (86) mit seiner nach oben gerichteten aktiven Seite eine flache Antenne (92) aus leitender Substanz mit geringer Viskosität und elastisch ist.

## Claims

1. An electronic device, such as a smart card, that includes at least one microcircuit (44; 80; 86; 102) which is embedded in a support card (40; 84; 98) and which is provided with outlet tabs (46, 48; 76, 78; 88, 90; 104) that are connected to interface elements constituted by a terminal block (50, 52; 106) and/or an antenna (70; 92; 99; 103), in which device the connections (54, 56; 72, 74; 105; 108) between the outlet tabs (46, 48; 76, 78; 88, 90; 104) and the interface elements are formed with a conductive substance;
said device being **characterized in that** the conductive substance, which is deposited using a syringe or the like, is of low viscosity and remains flexible after being applied and polymerized, and the deposit forms a bead.

2. A device according to claim 1, **characterized in that** the terminal block (106) is made of a conductive substance that is flexible and of low viscosity.

3. A device according claim 1, **characterized in that** an antenna (92) is made of a conductive substance that is flexible and of low viscosity.

4. A device according to any one of claims 1 to 3, **characterized in that** the substance is a polymer resin filled with conductive particles.

5. A device according to any one of claims 1 to 3, **characterized in that** the substance is a polymer resin filled with intrinsically conductive particles.

6. A device according to any one of claims 1 to 5, **characterized in that** the outlet tabs comprise non-oxidizing metal plating.

7. A device according to claim 2, **characterized in that** it is a contact smart card, a card body (40) being provided with a cavity (42), the microcircuit (44) being fixed with its active face upwards into the cavity (42), the terminal block (50, 52) and the connections (54, 56) being made of a conductive substance, and **in that** the microcircuit (44) is potted.

8. A device according to claim 7, **characterized in that** the microcircuit (44) is provided with contact bumps.

9. A device according to claim 8, **characterized in that** the cavity (58) has a recess (60) in its bottom (62), which recess receives the microcircuit (44).

10. A device according to claim 1, **characterized in that** it is a contactless smart card or an electronic label, with an antenna laid flat, **in that** the microcircuit (64) is fixed to the card with its active face upwards, and **in that** the connections (72, 74) between the outlet tabs (76, 78) of the microcircuit and the tabs (68, 70) of the antenna are made of a conductive substance that is flexible and of low viscosity.

11. A device according to claim 1, **characterized in that**, on the microcircuit (86) with its active face upwards, a flat antenna (92) is made of a conductive substance that is flexible and of low viscosity.
